Europäisches Patentamt

European Patent Office

Office européen des brevets

(11) Publication number: **0 246 432 B1**

## EUROPEAN PATENT SPECIFICATION

(45) Date of publication of patent specification: **08.07.92**   (51) Int. Cl.⁵: **H05K 7/20**

(21) Application number: **87104935.9**

(22) Date of filing: **03.04.87**

(54) **Fluid impingement heatsink with crossflow capability.**

(30) Priority: **19.05.86 US 864695**

(43) Date of publication of application:
**25.11.87 Bulletin 87/48**

(45) Publication of the grant of the patent:
**08.07.92 Bulletin 92/28**

(84) Designated Contracting States:
**DE FR GB IT**

(56) References cited:
**EP-A- 019 780**
**EP-A- 029 501**
**US-A- 3 348 609**
**US-A- 3 678 993**

**32nd Electronic Components Conference May 1982, U.S., page 145 - 149; Tuckerman et al.: "Ultrahigh thermal conductance microstructures for cooling integrated circuits"**

**I.B.M. TECHNICAL DISCLOSURE BULLETIN vol. 27, No. 3, August 1984, New York, page 1438, Furkay et al.: "Integral heat sink / module cap."**

(73) Proprietor: **International Business Machines Corporation**
**Old Orchard Road**
**Armonk, N.Y. 10504(US)**

(72) Inventor: **Kasdagly, Dino G.**
**R.D. No. 2, Box 323**
**Rome, PA 18837(US)**
Inventor: **Timko, Nicholas, Jr.**
**21 Enid Place**
**Johnson City, NY 13790(US)**

(74) Representative: **van Baarzel, Hermanus Jacobus et al**
**Intellectual Property Department IBM Nederland N.V. Watsonweg 2**
**NL-1423 ND Uithoorn(NL)**

## Description

Background of the Invention

The present invention relates to heatsinks and, more particularly, to heatsinks for use with electrical apparatus that can be adapted for use either in impingement cooling operations or in crossflow cooling operations. A heatsink according to the first part of claim 1 is known e.g. from IBM technical disclosure bulletin, Vol. 27, No 3, August 1984, "Integral heat sink/module cap", S.S. Furkay et al, page 1438.

In the field of electronic computer systems there is a tendency for a significant amount of heat to be generated by electrical components and circuitry. It is necessary to dissipate such heat and to cool such electrical components and circuitry. In fact, without a mechanism for cooling electrical devices, overheating may seriously and deleteriously affect the larger units of which they form a part, resulting in system performance degradation, nonrecoverable error generation, other malfunctions or even catastrophic system failure. The problem of undesirable heat accumulation is exacerbated in systems incorporating high power components or in which a great number of components are located in a relatively small volume of space.

Engineers have developed methods of removing heat from operating electrical devices. One of the more efficient methods of removing heat has been by the use of fluids, which may be in liquid or in gaseous form, such as water, freon, cooled or super-cooled gases (e.g., liquid nitrogen) and the like. The fluids represent a medium by which heat can be dissipated or redirected as the fluids are forced to flow across a heat dissipating device.

In general, the two major concepts used in fluid-based heatsinks involve serial or crossflow cooling, in which fluid is caused to flow across a heatsink element, and impingement cooling, in which a fluid is caused to be driven against the heatsink.

The use of liquids as a heat transfer medium in electronic cooling environments is beset by many disadvantages. For example, elaborate plumbing fixtures and other mechanisms are often required in order to recirculate a liquid and in order to utilize the cooling effects thereof. Moreover, because certain liquids can reach extremely low temperatures, in relatively humid environments condensation of moisture on plumbing fixtures known as sweating can occur. Sweating results in moisture accumulation and the possibility of liquid dripping onto electrical devices, eventually shorting, rusting or otherwise damaging them and affecting proper operation thereof. In order to help minimize or eliminate such adverse effects of sweating, insulation is often added to liquid cooled systems, increasing the cost, bulk and complexity thereof.

Another significant disadvantage of many liquid cooled systems is the great amount of space and apparatus required to pump, store and circulate liquid from holding areas to the environment of the devices to be cooled. Heat exchangers, for example, invariably require the use of two fluids in order to implement the heat exchange procedure.

Many of the aforementioned space and cost disadvantages are overcome by heatsinks which use a gas as the medium of heat transfer or exchange.

U.S. Patent 4,277,816 issued to Dunn et al discloses an air impingement concept for a heatsink for use with modules having a plurality of integrated circuit chips mounted thereon. The heatsink shown with this concept allows air to be directed against the multichip modules by means of an air-moving device (AMD) for cooling effects.

U.S. Patent 4,296,455 issued to Leaycraft et al discloses an air impingement heatsink for use with modules having a plurality of integrated circuit chips mounted thereon. Hollow fin or straight fin heatsinks are provided with slits to allow air to be distributed in a plurality of directions.

U.S. Patent 3,678,993 issued to Pierce discloses a heat exchange coil and housing. The heat exchanger comprises serpentine tubing which is adapted to be connected to a source of cooled or heated fluid as desired. The heat exchange coil is disposed diagonally within a housing, the housing having removable panel members. Air can be forced to enter or to be exhausted from one direction or another depending on the arrangement of the housing panels. The plurality of air flow directions is achieved at the expense of a substantial increase in the size of the unit due to the requirement that the heat exchanger be angled in the housing. The directions of air flow are all in one plane, in two dimensions.

U.S. Patent 3,348,609 issued to Dubin et al discloses a multi-positional power supply module and heat exchange techniques. The panels are removably mounted in a frame. The panels are actually heatsinks remote from the components that generate heat. A connecting device is therefore needed to conduct the heat from the source thereof (i.e., electrical devices) to the heatsink.

It would be advantageous to provide a heatsink that operates on the basis of gas and, preferably, air alone.

It would further be advantageous to provide a heatsink that would allow either impingement or crossflow cooling as required on the spot.

It would further be advantageous to provide a heatsink mechanism in the smallest possible size or package or having the least possible volume.

It would further be advantageous to allow flexibility in the heatsink configuration so that changing from impingement to crossflow cooling could be effected with the least amount of effort.

It would further be advantageous to provide a system in which the same heatsink could be adapted for use in either of two different applications: impingement cooling and crossflow cooling.

Summary of the Invention

In accordance with the present invention, as claimed, there is provided a fluid impingement heatsink structure in which a heatsink has a plurality of cooling fins and a substantially planar enveloping surface. A solid shroud can be placed on the heatsink to cover the planar surface so that fluid may flow serially across the fins but is prevented from flowing in a direction perpendicular to the plane defined by the planar enveloping surface. When the shroud is mounted on the heatsink, the heatsink and shroud form a unitary heatsink structure.

Brief Description of the Drawings

A complete understanding of the present invention may be obtained by reference to the accompanying drawings, when taken in conjunction with the detailed description thereof and in which:

FIG. 1 is a perspective view of a heatsink and shroud of the present invention;

FIG. 2 is a cross sectional view of a shroud mounted on a heatsink to form a unitary heatsink structure in accordance with the present invention;

FIG. 3 is a diagram showing the impingement cooling configuration of the present invention with no shroud attached;

FIG. 4 is a diagram showing the configuration conducive to crossflow air flow of the present invention with the shroud attached to the heatsink;

FIG. 5 depicts an alternate embodiment of the present invention in which the heatsink comprises pin cooling fins; and

FIG. 6 is a perspective view of yet an alternative embodiment of the present invention in which the heatsink comprises slotted cylindrical cooling fins.

Detailed Description of the Preferred Embodiments

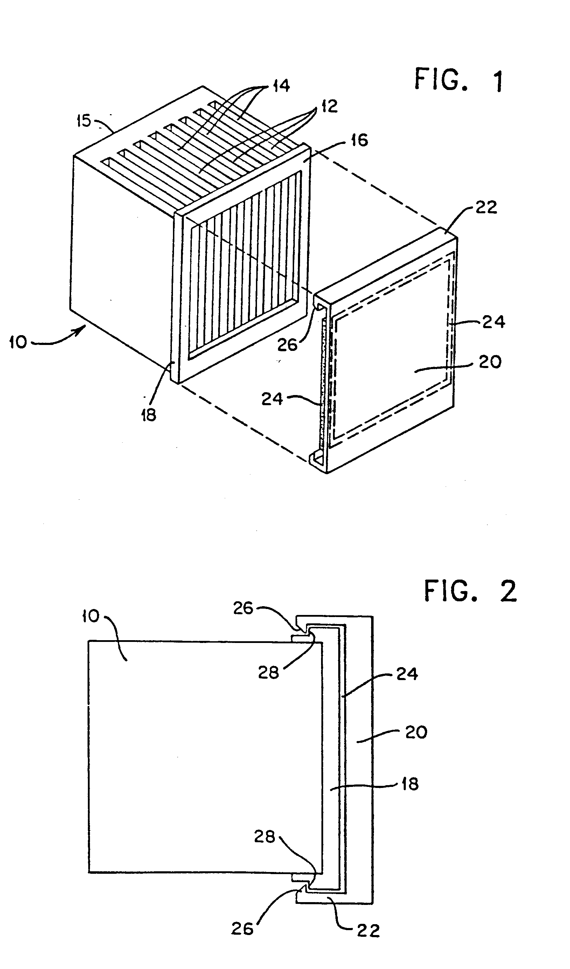

Referring now to FIG. 1, there is provided a heatsink 10. The dimensions of the heatsink are chosen as a function of both the size and the number of components, not shown, to be cooled. Conventional heatsinks can be manufactured by a die casting, brazing or, preferably, extrusion technique and are made of heat conductive material such as metal. The heatsink 10 has a plurality of straight cooling fins 12 arranged in a parallel configuration with air spaces, channels or apertures 14 being formed between them. The shape and configuration of fins 12 can vary, as hereinbelow described, in accordance with design objectives.

The heatsink 10 also has a substanially flat base 15 which, in operation, is placed in proximity to, or in physical contact with, the component(s), not shown, to be cooled. The spaces 14 are provided to allow a fluid to flow between the straight cooling fins 12. Depending upon the method of manufacture, the fins 12 can be an integral part of the heatsink base 15 or can be individually attached thereto by welding, bolting or other suitable means.

An impingement plate or mounting plate 16 is permanently mounted by suitable means to the heatsink 10 opposite, and substantially parallel to, the base 15. It should be noted that the impingement plate 16 may be removably mounted to the heatsink 10 in alternate embodiments of the present invention. The impingement plate 16 is a structure having four overlapping or mutually connected edges 18 framing a rectangular or square aperture through which fluid may be introduced to the heatsink 10 perpendicular to the plane of the base 15. The perimeter of the impingement plate 16 is greater than the outside dimensions of the heatsink. Thus, the impingement plate 16 overlaps or cantilevers the heatsink housing 10 to form a mounting surface.

A detachable cover plate or shroud 20 is designed to be mounted on the impingement plate 16 of the heatsink 10. The shroud 20 has a substantially flat, solid major surface and two mounting edges 22 oppositely disposed to one another. The interior surface of the shroud 20 has mounted thereon an O-ring 24, made of an elastomeric material such as rubber or foam rubber. The O-ring 24 is used to provide a positive contact between the shroud 20 and the impingement plate 16 of the heatsink 10, forming a seal so that fluid is not permitted to escape through the formed interface.

Attached by suitable means to, or forming a part of, the mounting edge 22 is a pair of mounting protuberances 26 suitable for positively engaging the impingement plate 16. In the preferred embodiment, the mounting protuberances 26 are made of a resilient material such as hard rubber or plastic so that the shroud 20 can be snapped onto the heatsink 10 without the need of tools, but merely by pressing the shroud 20 firmly against the impingement plate 16. If the mounting protuberances 26 are made of stiffer material such as metal, however, the shroud 20 can be mounted by sliding it transversely over the impingement plate 16 into position, once again without tools. The method of sliding the shroud 20 onto the impingement plate 16 is preferred when the mounting protuberance material is too stiff to deform by hand or is likely to be permanently misshapen when bent.

Referring now also to FIG. 2 there is shown a cross sectional view of a heatsink 10 of the present invention having a shroud 20 mounted thereon. The mounting protuberances 26 of the shroud 20 engage and are seated against respective rear surface indents 28 of the impingement plate 16, thus ensuring positive engagement therewith.

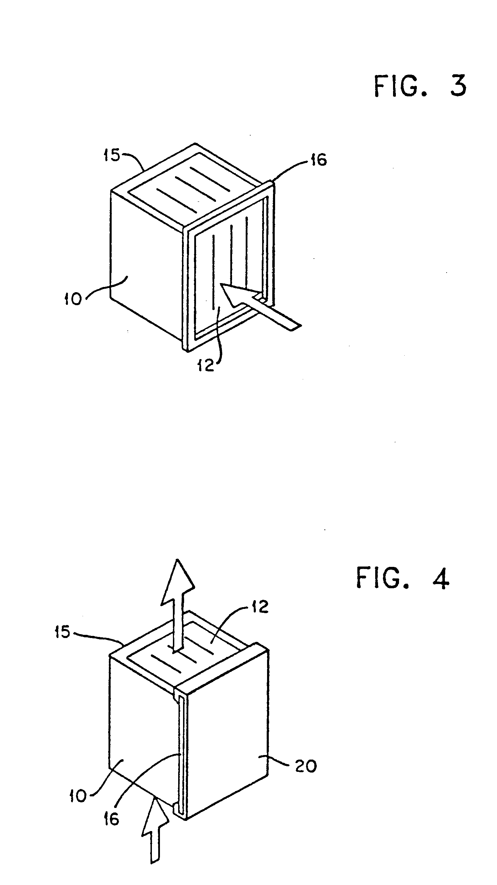

Referring now also to FIG. 3, there is shown a heatsink 10 to which is attached an impingement plate 16, but without a shroud. Fluid can be directed to flow in a direction perpendicular to the plane of the base 15, as shown by the arrow in FIG. 3. Fluid so directed is caused to impinge against the base 15 and thence to be ejected parallel to the plane of the base 15 in an upward or downward direction, assuming the straight cooling fins 12 are disposed substantially vertically, as shown. The heatsink configuration shown in FIG. 3 represents a conventional impingement cooling device but with the addition of the permanently mounted impingement plate 16.

Referring now also to FIG. 4, there is shown a heatsink 10 and impingement plate 16 in accordance with the present invention on which is mounted a shroud 20. Fluid that enters the heatsink 10 from below is thence ejected in an upward direction parallel to the plane of the base 15, as shown by the arrows in FIG. 4. This heatsink configuration (when so mounted) represents a conventional serial or crossflow device in which fluid is caused to pass through the air spaces or channels 14, thus dissipating heat generated against the base 15 by electronic components, not shown.

It can be seen that by mounting the shroud 20 on the heatsink 10, the heatsink unit becomes suitable for serial or crossflow operation, whereas by removing the shroud 20, the heatsink unit is adapted for impingement cooling.

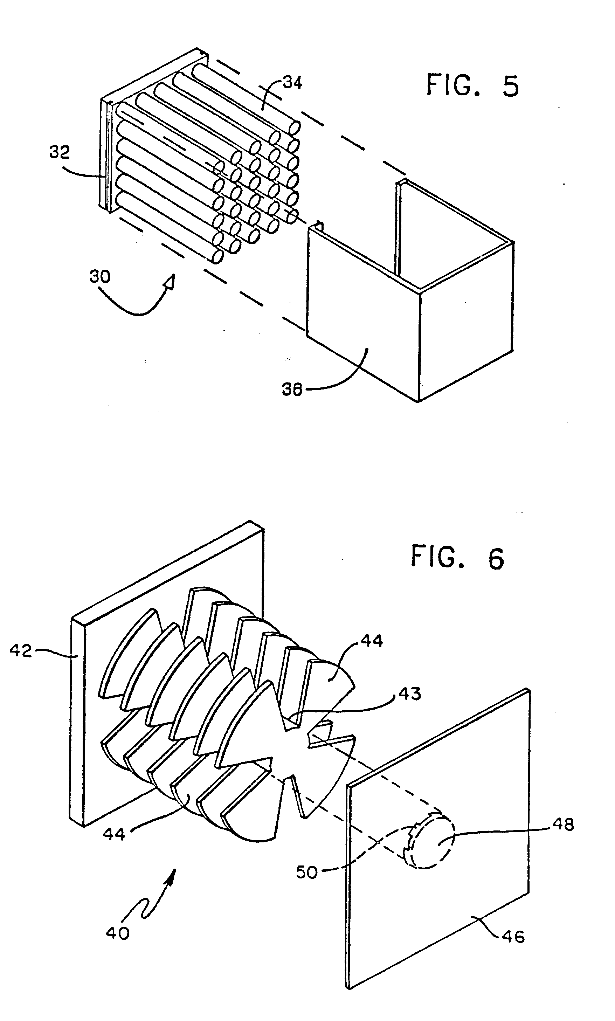

Referring now also to FIG. 5, there is shown an alternate embodiment of the present invention. A heatsink 30 comprises a base 32 on which are mounted a plurality of pin cooling fins 34. Although pin cooling fins 34 generally suffer from the disadvantage of not being extrudable, therefore requiring more expensive die cast manufacture, it has been found that in certain applications heat dissipation of pin cooling fins is greater than that of straight cooling fins.

A three-paneled shroud 36 is mountable on the heatsink base 32 in this configuration to prevent fluid from moving in a direction perpendicular to the plane of the base 32. Removing the shroud 36 from the base 32 once again allows and promotes impingement cooling.

Referring now also to FIG. 6, there is shown yet another embodiment of the present invention. A heatsink 40 has a base 42 to which is attached a center post 43. The center post 43 supports a plurality of slotted cylindrical cooling fins 44 aligned and disposed in spaced apart parallel relationship with one another in the preferred embodiment. The cylindrical cooling fin concept can be a useful and cost effective alternative to pin cooling fins and, in some environments, offers advantages over straight cooling fins.

A substantially flat plate shroud 46 is provided for use in conjunction with the heatsink 40. The shroud 46 has a central mounting region 48 to which are attached clips 50. The clips 50 are suitable for mounting the shroud 46 to the topmost cylindrical cooling fin 44 and its supporting center post 43. The clips 50 and shroud 46 must be fabricated of relatively resilient material so that assembly of the shroud 46 and cylindrical fin 44 can be performed by snapping the clips 50 of the former to latter without tools. Fluid is thus prevented from impinging perpendicularly against the base 42 when the shroud 46 is mounted. Instead, fluid is caused to flow in a direction parallel to the plane of the base 42, producing a crossflow heat dissipation effect. Conversely, removing the shroud 46 from the topmost cylindrical cooling fin 44 once again allows and promotes impingement cooling.

Thus it can be seen that for efficient operation, shape and size of the shroud is dependent upon the configuration and type of heatsink cooling fins used therewith. The scope of the present invention, therefore, is not limited to one particular configuration or cooling fin design, but is directed to the concept of a shroud used to convert an impingement heatsink device to a crossflow heatsink device in a simple, efficient and cost-effective manner.

## Claims

1. A fluid impingement heatsink structure (10, 30, 40) comprising:

    a) a heatsink having a base (15, 32, 42) and mounted thereon a plurality of cooling fins (12, 34, 44) and

    b) a shroud (20, 36, 46) for covering a substantially planar surface of the heatsink so that fluid can flow serially across said cooling fins but is prevented from flowing in a direction perpendicular to the plane defined by said planar surface when said shroud is mounted on the heatsink to form a unitary heatsink structure,

    characterized in that the shroud is removable connected to the heatsink so that fluid can flow substantially perpendicular to -and through- the said planar surface when said shroud is not mounted on the said heatsink.

2. The fluid impingement heatsink structure in accordance with claim 1 wherein said fluid comprises a liquid.

3. The fluid impingement heatsink structure in accordance with claim 2 wherein said liquid is selected from the group comprising water, freon and liquid nitrogen.

4. The fluid impingement heatsink structure in accordance with claim 1 wherein said fluid comprises a gas.

5. The fluid impingement heatsink structure in accordance with claim 4 wherein said gas comprises air or helium.

6. The fluid impingement heatsink structure in accordance with claim 1 wherein said heatsink has a mounting plate (16) operatively connected thereto for receiving said shroud.

7. The fluid impingement heatsink structure in accordance with claim 6 wherein said shroud comprises attachment means (22, 26, 48, 50) for connecting said shroud to said mounting plate.

8. The fluid impingement heatsink structure in accordance with claim 1 further comprising:
   c) sealing means (24) operatively connected to said shroud to prevent fluid leakage.

9. The fluid impingement heatsink structure in accordance with claim 8 wherein said sealing means comprises a resilient material, such as rubber.

10. A fluid impingement heatsink structure in accordance with claim 1, wherein said removable shroud covers three planar surfaces, so that fluid can flow across said cooling fins in a direction substantially parallel to the three planar surfaces when said shroud is mounted on the heatsink and so that fluid can flow through each of the three planar surfaces when said shroud is not mounted on the said heatsink.

**Revendications**

1. Structure de radiateur à flux de fluide frontal (10,30,40) comprenant :

(a) un radiateur comportant une base (15,32,42) sur laquelle sont montées une pluralité d'ailettes de refroidissement (12,34,44), et

(b) un capot (20,36,46) pour couvrir une surface sensiblement plane du radiateur de sorte que le fluide peut s'écouler sériellement transversalement aux dites ailettes de refroidissement mais est empêché de s'écouler dans une direction perpendiculaire au plan défini par la dite surface plane lorsque ledit capot est monté sur le radiateur de manière à constituer une structure de radiateur unitaire,

caractérisée en ce que le capot est relié de façon démontable au radiateur, de sorte que le fluide peut s'écouler sensiblement perpendiculairement à ladite surface plane, et à travers celle-ci, lorsque ledit capot n'est pas monté sur ledit radiateur.

2. Structure de radiateur à flux de fluide frontal suivant la revendication 1, dans laquelle ledit fluide est un liquide.

3. Structure de radiateur à flux de fluide frontal suivant la revendication 2, dans laquelle ledit liquide est choisi dans le groupe comprenant l'eau, le fréon et l'azote liquide.

4. Structure de radiateur à flux de fluide frontal suivant la revendication 1, dans laquelle ledit fluide est un gaz.

5. Structure de radiateur à flux de fluide frontal suivant la revendication 4, dans laquelle ledit gaz est de l'air ou de l'hélium.

6. Structure de radiateur à flux de fluide frontal suivant la revendication 1, dans laquelle ledit radiateur comprend une plaque de montage (16) reliée fonctionnellement au radiateur pour recevoir ledit capot.

7. Structure de radiateur à flux de fluide frontal suivant la revendication 6, dans laquelle ledit capot comprend des moyens de fixation (22,26,48,50) pour relier ledit capot à ladite plaque de montage.

8. Structure de radiateur à flux de fluide frontal suivant la revendication 1, comprenant en outre :
   (c) des moyens d'étanchéité (24) reliés fonctionnellement audit capot pour empêcher une fuite de fluide.

9. Structure de radiateur à flux de fluide frontal suivant la revendication 8, dans laquelle lesdits moyens d'étanchéité comprennent une matière élastique, telle que du caoutchouc.

10. Structure de radiateur à flux de fluide frontal suivant la revendication 1, dans laquelle ledit capot démontable recouvre trois surfaces planes, de sorte que le fluide peut circuler transversalement aux dites ailettes de refroidissement dans une direction sensiblement parallèle aux trois surfaces planes lorsque ledit capot est monté sur le radiateur, et de sorte que le fluide peut circuler à travers chacune des trois surfaces planes lorsque ledit capot n'est pas monté sur ledit radiateur.

## Patentansprüche

1. Kühlkörperaufbau (10, 30, 40) zum Beaufschlagen mit einem Fluid, enthaltend:
   a) einen Kühlkörper mit einem Grundkörper (15, 32, 42) und einer Mehrzahl darauf angeordneter Kühlrippen (12, 34, 44) und
   b) eine Abdeckung (20, 36, 46), um eine im wesentlichen ebene Oberfläche des Kühlkörpers so abzudecken, daß das Fluid quer über die Kühlrippen strömen kann, jedoch daran gehindert ist, in einer Richtung senkrecht zu der durch die ebene Oberfläche definierten Ebene zu strömen, falls die Abdeckung unter Bildung eines einheitlichen Kühlkörperaufbaus auf dem Kühlkörper montiert ist,
   dadurch gekennzeichnet, daß die Abdeckung entfernbar mit dem Kühlkörper verbunden ist, sodaß das Fluid im wesentlichen senkrecht zu der ebenen Oberfläche -und durch diese hindurch- strömen kann, falls die Abdeckung nicht auf dem Kühlkörper montiert ist.

2. Kühlkörperaufbau nach Anspruch 1, bei welchem das Fluid eine Flüssigkeit ist.

3. Kühlkörperaufbau nach Anspruch 2, bei welchem die Flüssigkeit aus der Gruppe enthaltend Wasser, Freon und flüssigen Stickstoff ausgewählt ist.

4. Kühlkörperaufbau nach Anspruch 1, bei welchem das Fluid ein Gas ist.

5. Kühlkörperaufbau nach Anspruch 4, bei welchem das Gas Luft oder Helium ist.

6. Kühlkörperaufbau nach Anspruch 1, bei welchem der Kühlkörper eine mit ihm wirksam verbundene Montageplatte (16) besitzt, welche die Abdeckung aufnehmen kann.

7. Kühlkörperaufbau nach Anspruch 6, bei welchem die Abdeckung Befestigungsmittel (22, 26, 48, 50) zur Verbindung mit der Montageplatte besitzt.

8. Kühlkörperaufbau nach Anspruch 1, welcher weiters enthält:
   c) ein Dichtmittel (24), das zur Verhinderung eines Fluidaustritts wirksam mit der Abdeckung verbunden ist.

9. Kühlkörperaufbau nach Anspruch 8, bei welchem das Dichtmittel elastisches Material, wie Gummi, enthält.

10. Kühlkörperaufbau nach Anspruch 1, bei welchem die entfernbare Abdeckung drei ebene Oberflächen abdeckt, sodaß das Fluid in einer Richtung im wesentlichen parallel zu den drei ebenen Oberflächen über die Kühlrippen strömen kann, falls die Abdeckung auf dem Kühlkörper montiert ist, und sodass das Fluid durch jede der drei ebenen Oberflächen strömen kann, falls die Abdeckung nicht auf dem Kühlkörper montiert ist.

FIG. 1

FIG. 2

FIG. 3

FIG. 4

FIG. 5

34

32

30

36

FIG. 6

42

44

43

44

48

50

46

40